Europäisches Patentamt

European Patent Office

Office européen des brevets

(19)

(11) Publication number: **0 228 226 B1**

(12) **EUROPEAN PATENT SPECIFICATION**

(45) Date of publication of patent specification: **04.03.92**   (51) Int. Cl.⁵: **H03K  17/73**

(21) Application number: **86309762.2**

(22) Date of filing: **15.12.86**

(54) **An off-gate circuit for a gate-turn-off thyristor.**

(30) Priority: **16.12.85 JP 282402/85**

(43) Date of publication of application:
**08.07.87 Bulletin  87/28**

(45) Publication of the grant of the patent:
**04.03.92 Bulletin  92/10**

(84) Designated Contracting States:
**CH DE GB LI SE**

(56) References cited:
**DE-A- 2 812 632**
**DE-A- 3 517 467**
**GB-A- 1 583 620**
**US-A- 3 940 633**
**US-A- 4 464 585**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Tsuruta, Yukinori Patent Division**
**Toshiba Corporation Principal Office**
**1-1, Shibaura 1-cho. Minato-ku Tokyo 105(JP)**
Inventor: **Kawakami, Kazuto Patent Division**
**Toshiba Corporation Principal Office**
**1-1, Shibaura 1-cho. Minato-ku Tokyo 105(JP)**

(74) Representative: **Kirk, Geoffrey Thomas**
**BATCHELLOR, KIRK & CO. 2 Pear Tree Court**
**Farringdon Road**
**London EC1R 0DS(GB)**

## Description

This invention relates to an off-gate circuit for a gate-turn-off thyristor (GTO thyristor).

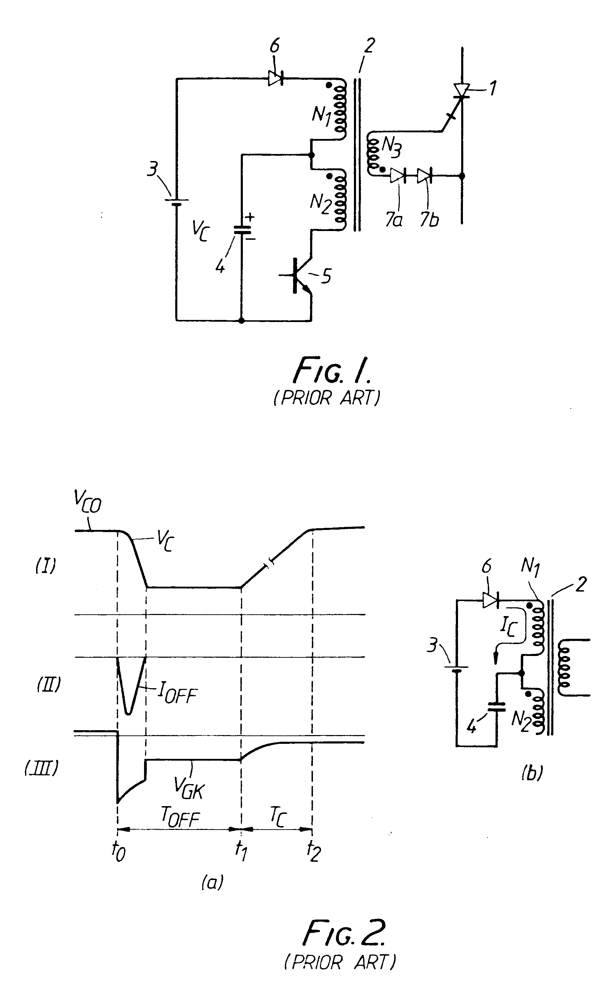

It is known from US-A-4 464 585 an off-gate circuit which is shown in Figure 1 of the accompanying drawings and Figures 2a(I)(II)(III) illustrate respective waveforms in the operation of the circuit shown in Figure 1.

In Figure 1, a GTO thyristor 1 has its gate connected to one end of a secondary winding $N_3$ of a pulse transformer 2, and its cathode connected through diodes 7a and 7b to the other end of the secondary winding $N_3$. A gate power source 3 is connected through a diode 6 to one end of a primary winding $N_1$ of the pulse transformer 2 so as to supply gate power. The other end of the primary winding $N_1$ is connected to one end of a primary winding $N_2$ and also to one end of a capacitor 4. The other end of the primary winding $N_2$ is connected through a transistor 5 to the other end of the capacitor 4 and also to the negative side of the gate power source 3.

Waveform 2(a)(I) represents a voltage waveform $V_C$ across the capacitor 4, waveform 2-(a)(II) represents an off-gate current $I_{OFF}$ produced from the secondary winding $N_3$ of the pulse transformer 2, and waveform 2(a)(III) represents a voltage waveform $V_{G-K}$ between the gate and cathode of the GTO thyristor 1.

At a time $t_O$, the capacitor 4 is charged with a polarity $V_{CO}$. The transistor 5 is then turned on when a base signal is fed to the transistor. The charge on the capacitor 4 is then discharged through the primary winding $N_2$ of the pulse transformer 2 and the transistor 5 so as to induce a voltage within the secondary winding $N_3$. This voltage produces an output current $I_{OFF}$ in the secondary winding $N_3$. The current $I_{OFF}$ is produced as a negative current between the cathode and the gate of the GTO thyristor 1. Diodes 7a and 7b prevent penetration of the on-gate current of an on-gate current circuit (not shown). During the period $T_{OFF}$ from the time $t_O$ to a time $t_1$, the base signal is fed into the transistor 5 which remains turned on. After the period $T_{OFF}$, should the transistor 5 be turned off at the time $t_1$, an exciting current of the pulse transformer 2 flows through a path of the positive side of the gate power source 3, the diode 6, the primary winding $N_1$ of the pulse transformer 2, the capacitor 4, and the negative side of the gate power source 3, whereby the capacitor 4 is recharged. An equivalent circuit in this state is shown in Figure 2(b).

In recent years, there has been a need for a power converter apparatus employing larger-capacity GTO thyristors. With such thyristors, one of the requirements for satisfactory operation is that the rising rate $dI/dt$ of the gate reverse current should be large.

It is known from GB-A-1583620 for a gate circuit of a gate turn-off thyristor to include a power source connected to a capacitor and for switching means to discharge the capacitor to generate an off-gate current pulse between the gate and cathode of the thyristor. The pulse has a relatively large rising rate and a relatively narrow pulse width. In addition, a second circuit generates an off-gate current pulse having a relatively small rising rate and a relatively wide pulse width. The pulses are generated together and result in a pulse supplied to the thyristor which has a relatively large rising rate and a relatively wide pulse width.

Large capacity GTO thyristors have a significant switching loss which affects the thyristors thermally and, if the switching loss can be reduced, the switching frequency can be increased.

It is an object of the present invention to reduce turn-off loss of a GTO thyristor.

According to the present invention, a circuit for supplying turn-off current between the gate and cathode of a GTO thyristor comprises a power source; capacitor means coupled to the power source to be charged to a predetermined voltage level; and switching means for discharging the capacitor means to thereby generate an off-gate current pulse between the gate and cathode of the thyristor; characterised in that said switching means includes means for selectively discharging the capacitor means such that the increase in value of the current pulse has a first rate of change followed by a second rate of change which is a higher rate of change than the first rate of change so as to reduce turn-off loss of the thyristor.

In order that the invention may be more readily understood, it will now be described, by way of example only, with reference to the accompanying drawings, in which:-

Figure 3 is a schematic diagram illustrating one embodiment according to the present invention;

Figures 4(a) and 4(b) are characteristic diagrams of GTO thyristors explaining the preferred embodiment of the present invention;

Figures 5(I) to 5(V) are waveform diagrams of respective parts explaining the preferred embodiment of the present invention; and

Figure 6(a) to 6(c) are schematic diagrams illustrating other embodiments of the present invention.

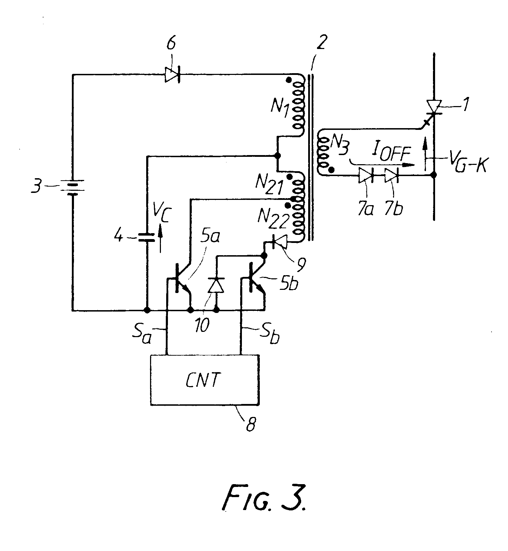

Referring now to Figure 3, one embodiment of the present invention will be described. In Figure 3, parts identical to or corresponding to those in Figure 1 are designated by like reference numerals so that the description thereof will be omitted. A terminal is provided on primary winding $N_2$ of pulse transformer 2 to form windings $N_{21}$ and $N_{22}$. A

transistor 5a is connected between the end of winding $N_{21}$ and the negative side of source 3 and transistor 5b is connected between the end of winding $N_{22}$ and the negative side of source 3. Base signals of the transistors 5a and 5b are supplied from an ON-OFF control circuit 8. A diode 9 prevents the winding $N_{22}$ from being short-circuited when the transistor 5a is turned on, while a diode prevents a reverse voltage from being applied to the transistor 5b.

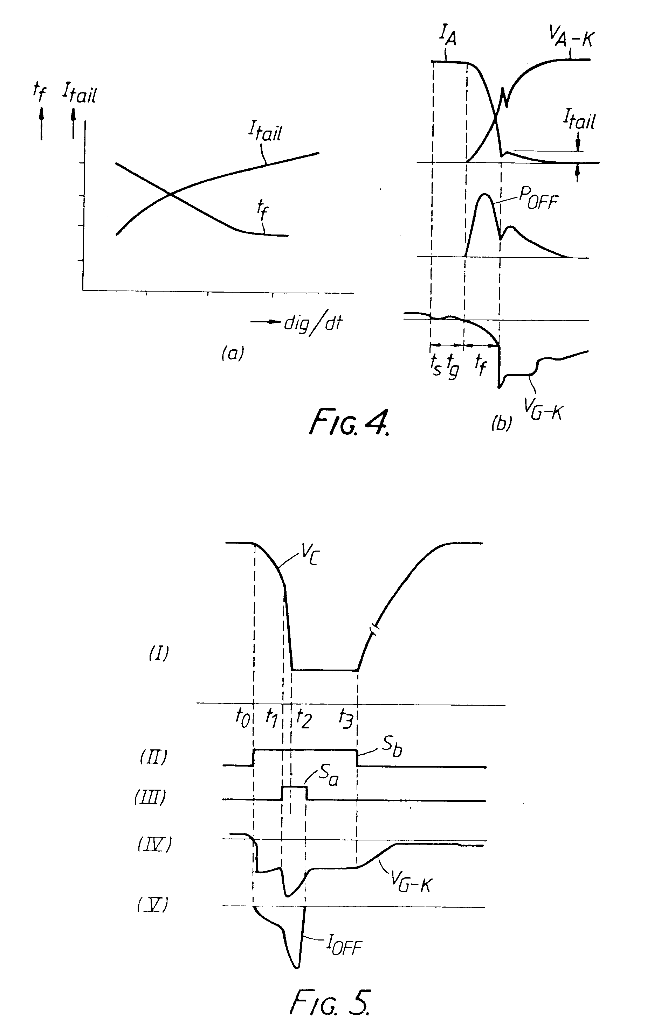

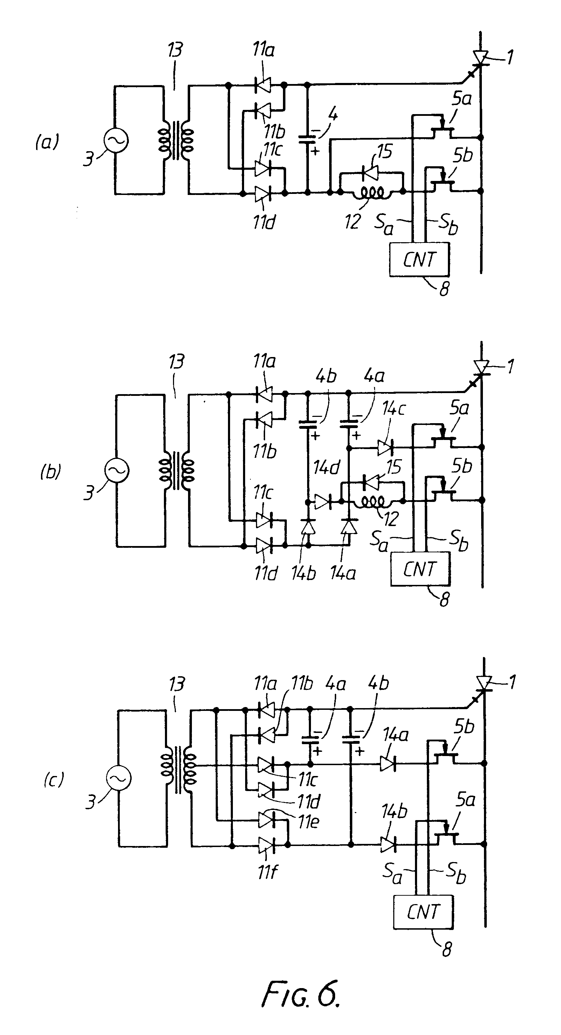

Next, operation of this embodiment will be described with reference to Figures 3, 4 and 5. In general, turn-off characteristics of GTO thyristors are such that when the off-current change rate dig/dt is lowered, the tail current becomes smaller. However, the gate power source voltage $E_g$ also becomes lower when the change rate dig/dt is lowered. When the gate power source voltage $E_g$ decreases, the fall time $t_f$ increases, and the maximum interruption current $I_{ATO}$ (max) tends to decrease by the amount of increased power loss caused by the lengthened fall time $t_f$. When the change rate dig/dt is increased, both the storage time $t_{stg}$ and the fall time $t_f$ decrease. However, the tail current $I_{tail}$ increases. This relationship between $t_f$ and $I_{tail}$ is shown in Figure 4(a). Figure 4(b) illustrates characteristics in the case of turn-off, which represent the relationship of an anode current $I_A$, a voltage $V_{A-K}$ between the anode and cathode, turn-off loss $P_{OFF}$, and a voltage $V_{G-K}$ between the gate and cathode. Instantaneous loss upon turn-off increases in proportion to increases of the fall time or the tail current. To reduce turn-off loss, the characteristics of the GTO thyristor should be utilised in a control method, as shown in Figure 5, with respect to the circuit of Figure 3. The change rate dig/dt in the first part of the storage time $t_{stg}$ is made to be lowered to decrease the tail current $I_{tail}$, and the change rate dig/dt in the latter part of the storage time $t_{stg}$ is made to be increased to decrease the fall time $t_f$.

The above control method is very effective to decrease the turn-off because the fall time $t_f$ is more influenced by the change rate dig/dt in the latter part of the storage time $t_{stg}$ than by that in the first part of the storage time $t_{stg}$. In Figure 5, (I) shows a waveform of the voltage across the capacitor 4, (II) a base control signal $S_b$ of the transistor 5b, (III) a base control signal $S_a$ of the transistor 5a, (IV) an assumed waveform between the gate and cathode of GTO thyristor when employing the control method, and (V) an off-gate current waveform. During the period from a time $t_0$ to a time $t_1$, the transistor 5b is turned on, and an off-gate current of lower change rate dig/dt is produced through the windings $N_{21}$ and $N_{22}$ in series. During the period from the time $t_1$ to a time $t_2$, the transistor 5a is turned on, and an off-gate current

$I_{OFF}$ of higher change rate is produced through the winding $N_{21}$. These operations are periodically repeated to perform necessary switchings. Other modified methods which do not use pulse transformers may be utilised to effect changeover from the off-gate current of lower dig/dt to the off-gate current of higher dig/dt.

These modified embodiments are shown in Figures 6(a), 6(b) and 6(c), wherein parts identical to those in Figure 3 are designated by identical reference numerals, so that the description thereof may be omitted. Reference numerals 11a to 11f designate diodes, 12 designates an impedance component (here, a reactor is described, for example), 13 designates a transformer, and 14a to 14d and 15 denote diodes. In Figure 6(a) a switching component 5b functions to suppress discharge of the charge on the capacitor 4 through an impedance component 12 to produce an off-gate current of lower dig/dt. Here, the reactor is described, for example, so that the diode 15 is provided in parallel therewith to suppress the occurrence of overvoltage. However, in the case of a resistor, such a diode is unnecessary. After a specified time has elapsed, a switching component 5a is turned on to produce an off-gate current of higher dig/dt. Further, as shown in Figure 6(b), a capacitor which supplies an off-gate current that changes from a lower dig/dt to a higher dig/dt may be separated into capacitors 4a and 4b. These are provided with diodes 14c and 14d, respectively, or suppressing cross currents between the capacitors 4a and 4b. Moreover, as shown in Figure 6(c), the impedance component 12 may be replaced by a transformer 13. The transformer 13 has a tap terminal so that the charged voltage of the capacitor 4a may be made lower than that of the capacitor 4b. A plurality of power sources of different voltages also may be provided, so that the operation of switching component 5b produces an off-gate current of lower dig/dt while operation of the switching component 5a produces an off-gate current of higher dig/dt.

## Claims

1. A circuit for supplying turn-off current between the gate and cathode of a GTO thyristor (1), said circuit comprising a power source (3); capacitor means (4) coupled to the power source to be charged to a predetermined voltage level; and switching means (5) for discharging the capacitor means to thereby generate an off-gate current pulse ($I_{OFF}$) between the gate and cathode of the thyristor (1); characterised in that said switching means (5) includes means (5a, 5b, 8) for selectively discharging the capacitor means such that the increase in value of the current pulse has a first rate of change followed by a second rate of change which is a higher rate of change than the first rate of change so as to reduce turn-off loss of the thyristor.

2. The circuit of claim 1, wherein the switching means includes transformer means (2) coupled between the power source, the capacitor means and the GTO thyristor, and comprising windings for receiving current, and for generating the off-gate current flow in the GTO thyristor in response to the discharging of the capacitor, characterised in the provision of first and second switches, the first switch (5b) being operatively connected to the transformer means for controlling the transformer means to generate off-gate current having the first rate of change of current flow, the second switch (5a) being operatively connected to the transformer means for controlling the transformer means to generate off-gate current having the second rate of change of current flow in the GTO thyristor; and control means (8) for controlling the first and second switches to selectively cause the switching means to generate the first and second rates of change for the off-gate current.

3. The circuit of claim 1, characterised in that the switching means includes first and second switches, the first switch (5b) being operatively connected to the capacitor means and the GTO thyristor for generating off-gate current having the first rate of change of current flow, the second switch (5a) being operatively connected to the capacitor and the GTO thyristor for generating off-gate current having the second rate of change of current flow in the GTO thyristor; and control means (8) for controlling the first and second switches to selectively cause the switching means to generate the first and second rates of change for the off-gate current.

4. The circuit of claim 3, characterised in that the capacitor means has an associated rate of discharge and the first switch (5b) includes impedance means (12, 15) for suppressing the rate of discharge of the capacitor means to generate the off-gate current having the first rate of change of current flow.

5. The circuit of claim 4, characterised in that the capacitor means includes first capacitor (4b) and second capacitor (4a), each being charged with the corresponding voltage; and wherein the first capacitor (4b) is operatively connected to the first switch (5b) and the second capacitor (4a) is operatively connected to the second switch (5a), the first and second switches being responsive to the first and second capacitors, respectively, to cause the switching means to generate the first and second rates of change for the off-gate current.

6. The circuit of claim 4 or 5, characterised in that the impedance means (12, 15) includes a reactor (12) having a diode (15) connected in parallel therewith.

7. The circuit of claim 3, characterised in that the capacitor means includes first and second capacitors (4a, 4b) chargeable with a first, lower voltage and a second, higher voltage, respectively, the first and second capacitors being charged by the power source; and wherein the first capacitor (4a) is operatively connected to the first switch (5b) and the second capacitor (4b) is operatively connected to the second switch (5a), the first and second switches being responsive to the first and second capacitors, respectively, to cause the switching means to generate the first and second rate of change for the off-gate current.

**Revendications**

1. Circuit pour appliquer un courant d'interruption ou de coupure entre la porte et la cathode d'un thyristor GTO (1), ledit circuit comprenant une source d'énergie électrique (3), un condensateur (4) monté entre la source d'énergie électrique afin d'être chargé à une tension électrique prédéterminée; et des moyens de commutation (5) pour décharger le condensateur afin d'engendrer ainsi une impulsion de courant de fermeture de porte $I_{OFF}$) entre la porte et la cathode du thyristor (1), caractérisé en ce que les moyens de commutation (5) comprennent des moyens (5a, 5b, 8) pour décharger sélectivement le condensateur de façon que l'augmentation de la valeur de l'impulsion de courant présente une première vitesse de variation suivie d'une seconde vitesse de variation qui est plus grande que la première afin de réduire les pertes de coupure du thyristor.

2. Circuit selon la revendication 1, caractérisé en ce que les moyens de commutation comprennent un transformateur (2) branché entre la source d'énergie électrique, le condensateur et le thyristor GTO, et comportant des enroulements pour recevoir un courant, et des moyens pour produire la circulation d'un courant de fermeture de porte dans le thyristor GTO en réponse au déchargement du condensateur, caractérisé par la présence d'un premier et d'un second commutateurs, le premier commutateur (5b) étant effectivement connecté au transformateur afin de commander le transformateur à produire un courant de fermeture de porte présentant une première vitesse de variation d'intensité, le second commutateur (5a) étant effectivement connecté au transformateur afin de commander celui-ci pour qu'il produise une seconde vitesse de variation de l'intensité du courant dans le thyristor GTO, et des moyens (8) pour commander le premier et le second commutateurs de façon qu'ils produisent la première et la seconde vitesses de variation du courant de coupure.

3.  Circuit selon la revendication 1, dans lequel les moyens de commutation comprennent un transformateur (2) branché entre la source d'énergie électrique, le condensateur et le thyristor GTO, et comprenant des enroulements pour recevoir le courant, et pour engendrer dans le thryristor GTO la circulation d'un courant de fermeture de porte en réponse au déchargement du condensateur, caractérisé par la présence de deux commutateurs, le premier conmmutateur (5b) étant effectivement connecté au transformateur afin de commander celui-ci à engendrer un courant de fermeture de porte présentant une première vitesse de changement d'intensité, le second commutateur étant effectivement connecté au transformateur afin de commander celui-ci à produire dans le thyristor GTO un courant de fermeture de porte présentant une seconde vitesse de variation d'intensité; et de moyens (8) pour commander les deux commutateurs de façon que les moyens de commutation produisent sélectivement la première et la seconde vitesses de variation d'intensité du courant de fermeture de porte.

4.  Circuit selon la revendication 3, caractérisé en ce que les condensateurs présentent une certaine vitesse de décharge, le premier commutateur (5b) incluant des impédances (12, 15) pour supprimer la vitesse de décharge des condensateurs afin d'engendrer un courant de fermeture de porte présentant la première vitesse de variation d'intensité.

5.  Circuit selon la revendication 4, caractérisé en ce qu'il comprend un premier condensateur (4b) et un second condensateur (4a), dont chacun est chargé à la tension correspondante; et en ce que le premier condensateur (4b) est effectivement connecté au premier commutateur (5b), tandis que le second condensateur (4a) est effectivement connecté au second commutateur (5a), ces deux commutateurs intervenant respectivement en réponse au premier et au second condensateurs, pour faire en sorte que les moyens de commutation produisent la première et la seconde vitesses de variation du courant de fermeture.

6.  Circuit selon la revendication 4 ou 5, caractérisé en ce que les impédances (12, 15) comprennent une réactance (12) sur laquelle une diode (15) est branchée en parallèle.

7.  Circuit selon la revendication 3, caractérisé en ce qu'il comprend un premier et un second condensateurs (4a, 4b) pouvant être chargés respectivement à une première tension électrique plus basse et à une seconde tension électrique plus élevée, ces deux condensateurs étant chargés par la source d'énergie électrique; et en ce que le premier condensateur (4a) est connecté effectivement au premier commutateur (5b), et le second condensateur (4b) est effectivement connecté au second commutateur (5a), ces deux commutateurs faisant respectivement en sorte, en réponse au premier et au seconds condensateurs, que les moyens de commutation produisent la première et la seconde vitesses de variation d'intensité du courant de fermeture de porte.

**Patentansprüche**

1.  Schaltung zur Zufuhr von Ausschaltsttrom zwischen die Steuerelektrode und die Kathode eines GTO-Thyristors (1), wobei der Schaltung umfaßt: eine Energiequelle (3), eine Kondensatorvorrichtung (4), die mit der Energiequelle verbunden ist, um auf eine vorbestimmte Spannungshöhe aufgeladen zu werden, und eine Schaltvorrichtung (5) zum Entladen der Kondensatorvorrichtung, um so zwischen der Steuerelektrode und der Kathode des Thyristors (1) einen Abschalt-Stromimpuls ($I_{OFF}$);zu erzeugen, **dadurch gekennzeichnet**, daß die Schaltvorrichtung (5) Einrichtungen (5a, 5b, 8) zum selektiven Entladen der Kondensatorvorrichtung beinhaltet, so daß der Anstieg des Wertes des Strompulses eine erste Steigung hat, die von einer zweiten Steigung gefolgt wird, die höher liegt als die erste, um den Abschaltverlust des Thyristors zu reduzieren.

2.  Schaltung nach Anspruch 1, wobei die Schaltvorrichtung eine Transformatorvorrichtung (2) umfaßt, die zwischen die Energiequelle, die Kondensatorvorrichtung und den GTO-Thyristor geschaltet ist, und die Windungen zur Aufnahme von Strom und zur Erzeugung des Abschaltstromflusses im GTO-Thyristor auf das Entladen des Kondensators hin hat, **gekennzeichnet** durch die Bereitstellung eines ersten und zweiten Schalters, wobei der erste Schalter (5b) funktionsmäßig an die Transformatorvorrichtung gekoppelt ist, um die Transformatorvorrichtung so zu steuern, daß diese Abschaltstrom mit einer ersten Steigung des Stromflusses erzeugt, und der zweite Schalter funktionsmäßig mit der Transformatorvorrichtung gekoppelt ist, um die Transformatorvorrichtung so zu steuern, daß diese den Abschaltstrom mit der zweiten Steigung des Stromflusses im GTO-Thyristor erzeugt; und eine Steuervorrichtung (8) zur Steuerung des ersten und zweiten Schalters, die wahlweise die Schaltvorrichtung veranlassen, die erste und zweite Steigung des Abschaltstroms zu erzeugen.

3. Schaltung nach Anspruch 1, **dadurch gekennzeichnet**, daß die Schaltvorrichtung erste und zweite Schalter hat, wobei der erste Schalter (5b) funktionsmäig an die Kondensatorvorrichtung und den GTO-Thyristor angeschlossen ist, um Abschaltstrom mit einer ersten Steigung des Stromflusses zu erzeugen, und wobei der zweite Schalter (5a) funktionsmäßig an die Kondensatorvorrichtung und den GTO-Thyristor angeschlossen ist, um Abschaltstrom mit einer zweiten Steigung des Stromflusses im GTO-Thyristor zu erzeugen; und daß eine Steuervorrichtung (8) zur Steuerung des ersten und zweiten Schalters vorhanden ist, die bewirkt, daß die Schaltvorrichtung wahlweise die erste und zweite Steigung des Abschaltstroms erzeugt.

4. Schaltung nach Anspruch 3, **dadurch gekennzeichnet**, daß die Kondensatorvorrichtung eine damit verbundene Entladerate hat und der erste Schalter (5b) eine Impedanzvorrichtung (12, 15) zum Absenken der Entladerate der Kondensatorvorrichtung zur Erzeugung des Abschaltstroms mit der ersten Steigung des Stromflusses aufweist.

5. Schaltung nach Anspruch 4, **dadurch gekennzeichnet**, daß die Kondensatorvorrichtung einen ersten Kondensator (4b) und einen zweiten Kondensator (4a) aufweist, wobei jedem von ihnen die jeweilige Spannung zugeführt wird, und wobei der erste Kondensator (4b) funktionsmäßig an den ersten Schalter (5b) angeschlossen ist und der zweite Kondensator (4a) funktionsmäßig an den zweiten Schalter (5a) angeschlossen ist, wobei der erste und zweite Schalter in Reaktion zu jeweils dem ersten bzw. dem zweiten Kondensator stehen, damit die Schaltvorrichtung ein Erzeugen der ersten und zweiten Steigung des Abschaltstroms bewirkt.

6. Schaltung nach Anspruch 4 oder 5, **dadurch gekennzeichnet**, daß die Impedanzvorrichtung (12, 15) eine Drosselspule (12) mit einer parallel dazu geschalteten Diode (15) aufweist.

7. Schaltung nach Anspruch 3, **dadurch gekennzeichnet**, daß die Kondensatorvorrichtung einen ersten und einen zweiten Kondensator (4a, 4b) aufweist, die mit einer ersten, niedrigeren Spannung bzw. einer zweiten, höheren Spannung aufgeladen werden können, wobei der erste und zweite Kondensator aus der Energiequelle aufgeladen werden, und wobei der erste Kondensator (4a) funktionsmäßig mit dem ersten Schalter (5b) und der zweite Kondensator (4b) funktionsmäßig mit dem zweiten Schalter (5a) verbunden ist, wobei der erste und zweite Schalter auf den ersten bzw. zweiten Kondensator reagieren, damit die Schaltvorrichtung zur Erzeugung einer ersten und einer zweiten Steigung für den Abschaltstrom veranlaßt wird.

*FIG. 1.*
*(PRIOR ART)*

*(a)*

*(b)*

*FIG. 2.*
*(PRIOR ART)*

7

FIG. 3.

FIG. 4.

FIG. 5.

FIG. 6.